# EUROPÄISCHE PATENTSCHRIFT

(11) **EP 0 405 334 B1**
(45) Veröffentlichungstag und Bekanntmachung des Hinweises auf die Patenterteilung: **29.03.1995**
(21) Anmeldenummer: 90111791.1
(22) Anmeldetag: 21.06.1990
(51) Int. Cl.: H01R 17/12

(54) **Mit einer Leiterplatte verbindbare Koaxialsteckverbinderhälfte oder Hochstromkontakt**
Coaxial connector half connectable with a printed circuit board or heavy current contact
Moitié d'un connecteur coaxial à connecter à une plaque à circuits imprimés ou contact pour courant fort

(30) Priorität: 26.06.1989 DE 8907785 U
(43) Veröffentlichungstag der Anmeldung: 02.01.1991
(73) Patentinhaber: SIEMENS AKTIENGESELLSCHAFT, 80333 München (DE)
(72) Erfinder: Houtteman, Bernard, B-8020 Oostkamp (BE); Mussen, Michel, B-9000 Gent (BE)

(56) Entgegenhaltungen:
- DE-U- 8 806 100
- US-A- 4 191 440
- US-A- 4 684 200
- US-A- 4 737 114

## Beschreibung

Die Erfindung bezieht sich auf eine Koaxialsteckverbinderhälfte zur Verbindung mit einer Leiterplatte, mit
a) einer hohlzylindrisch ausgebildeten metallischen Außenleiterhülse,
b) einem koaxial und isoliert in der Außenleiterhülse angeordneten zentralen Kontaktstift,
c) mindestens einem neben dem zentralen Kontaktstift an der Außenleiterhülse angeordneten peripheren Anschlußstift,
d) wobei der zentrale Kontaktstift und der periphere Anschlußstift in jeweils eine zugeordnete Bohrung der Leiterplatte einsteckbar und mit einer zum Eindrücken in die jeweilige Leiterplattenbohrung bestimmten, durch Aufspaltung des entsprechenden Stiftbereiches gebildeten Einpreßzone versehen sind.

Durch DE-U-8 806 100 ist eine die Merkmale a) bis d) aufweisende Steckkupplung für Koaxialleitungen bekannt. Hierbei ist der periphere Kontaktstift in einer an der Basis der Steckkupplung seitlich abstehenden Lasche vorgesehen, so daß hier eine Steckkupplung erforderlich ist, deren Außendurchmesser wesentlich größer ist als der Außendurchmesser des Außenleiters. Eine derart vergrößerte Steckkupplung benötigt auch einen entsprechend größeren Platz auf der Leiterplatte.

Ferner ist durch US-A-4,684,200 ein Koaxialanschluß mit den Merkmalen a) bis d) bekannt, bei dem die peripheren Kontaktstifte in einem seitlichen Flansch an der Basis des Koaxialanschlusses vorgesehen sind. Dieser Flansch ist relativ groß, so daß er das Außenmaß des Koaxialanschlusses an dessen Basis und damit auch den Platzbedarf auf der Leiterplatte nahezu verdreifacht.

Diese bekannten Einrichtungen erfordern also einen über den Außendurchmesser des Außenleiters hinausgehenden größeren Durchmesser des Koaxialanschlusses und damit einen erhöhten Platzbedarf auf der Leiterplatte.

Der Erfindung liegt daher die Aufgabe zugrunde, für eine Koaxialsteckverbinderhälfte der eingangs genannten Art einen möglichst kompakten Aufbau mit geringstmöglichem Platzbedarf auf der Leiterplatte anzugeben.

Diese Aufgabe wird bei einer Koaxialsteckverbinderhälfte mit den Merkmalen a) bis d) durch das zusätzliche Merkmal e) des Anspruchs 1 gelöst. Nach diesem Merkmal ist der periphere Anschlußstift in eine Längsbohrung in der Wandung der Außenleiterhülse eingesteckt. Dies hat den Vorteil einer äußerst kompakten, einfach aufgebauten und vorzufertigenden Ausführung eines Koaxialsteckverbinders, da die Kontaktstifte dem Koaxialsteckverbinder zugeordnet sind und sich innerhalb des Außendurchmessers des Koaxialsteckverbinders befinden und somit keine Vergrößerung des Koaxialsteckverbinders über den Durchmesser der Außenleiterhülse hinaus und dadurch keinen erhöhten Platzbedarf auf der Leiterplatte verursachen. Auch eine besondere Ausbildung oder Vorbereitung der Leiterplatte mit Kontaktstiften ist bei einem erfindungsgemäßen Koaxialsteckverbinder nicht nötig.

Außerdem kann im Rahmen der Erfindung vorgesehen sein, daß die peripheren Anschlußstifte zwischen dem nagelförmigen Abschnitt und der Einpreßzone mit einer flanschartigen Verbreiterung mit zur Einpreßzone weisenden Schultern ausgebildet sind.

Die Schultern ermöglichen es, den mit einer Einpreßzone versehenen Anschlußstift mit dem nagelförmigen Abschnitt in eine entsprechend bemessene Bohrung des Innenleiters oder des Außenleitergehäuses einzudrücken, bevor die Steckverbinderhälfte mit den Einpreßzonen in die Bohrungen einer Leiterplatte eingesteckt wird. Dadurch ist es möglich, die Steckverbinderhälfte und die mit den Einpreßzonen versehenen Anschlußstifte der Steckverbinderhälfte jeweils aus dem für das entsprechende Teil besonders geeigneten Material herzustellen.

Nachfolgend werden Ausführungsbeispiele der Erfindung anhand von vier Figuren noch näher erläutert.

Dabei zeigen, jeweils vergrößert und auf das wesentliche beschränkt
- Fig. 1: einen Hochstromkontakt, halbseitig geschnitten dargestellt, der mit einer ihm zugeordneten Einpreßzone in der Bohrung einer Leiterplatte sitzt,
- Fig. 2: einen Abschnitt einer Koaxialsteckverbinderhälfte, halbseitig geschnitten dargestellt, mit zum Einstecken in Bohrungen einer Leiterplatte vorstehenden Anschlußstiften,
- Fig. 3: den Gegenstand von Fig. 2 von der Stiftseite her gesehen und
- Fig. 4: einen gesondert hergestellten Anschlußstift, der in eine Bohrung einer Steckverbinderhälfte eingesteckt werden kann.

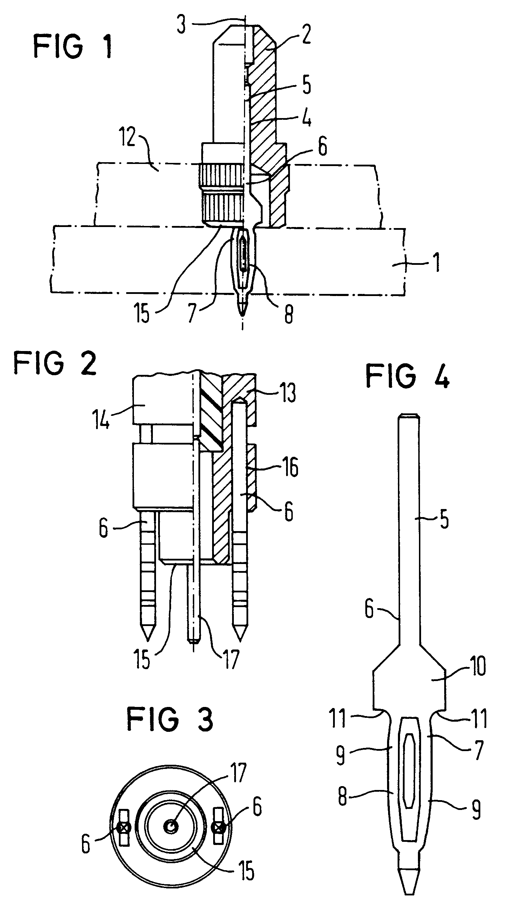

Im einzelnen ist den Figuren zu entnehmen, daß ein zur Verbindung mit einer Leiterplatte 1 vorgesehener Hochstromkontakt 2 einen zylindrisch ausgebildeten Metallkörper aufweist, der mit seiner Achse 3 rechtwinklig zur Leiterplatte 1 gerichtet, auf diese aufgesetzt ist. Auf der Leiterplattenseite 15 des Hochstromkontaktes 2 ist dieser mit einer konzentrischen Längsbohrung 4 versehen. In die Längsbohrung 4 ist ein nagelförmig ausgebildeter Stiftabschnitt 5 eines gesondert hergestellten Anschlußstiftes 6 (Fig. 4) eingesteckt. Der Anschlußstift 6 steht aus dem metallischen Körper des Hochstromkontaktes 2 in Richtung zur Leiterplatte 1 hin mit einem Stiftbereich 7 vor, der mit einer Einpreßzone 8 versehen ist. Die Einpreßzone 8 wird im wesentlichen durch eine Aufspaltung des Stiftbereiches 7 in zwei voneinander in einem bestimmten Abstand verlaufende Arme 9 erhalten. Beim Einstecken des mit der Einpreßzone 8 versehenen Stiftbereiches 7 in eine entsprechend bemessene Bohrung der Leiterplatte 1 werden die Arme 9 plastisch/elastisch gegeneinander gedrückt und dadurch die Einpreßzone 8 in der Leiterplattenbohrung verklemmt, wobei die der Bohrungswand anliegenden Arme 8 bei geeigneter Ausbildung für einen guten elektrischen Kontakt zwischen dem Anschlußstift 6 und der metallisierten Bohrungswand der Leiterplatte 1 sorgen.

Zwischen dem nagelförmig ausgebildeten Abschnitt 5 des Anschlußstiftes 6 und der Einpreßzone 8 ist eine flanschartige Verbreiterung 10 des Anschlußstiftes 6 vorgesehen. Dadurch werden zur Einpreßzone 8 gerichtete Schultern 11 gebildet, mit deren Hilfe der nagelförmig ausgebildete Abschnitt 5 des Anschlußstiftes 6 in die Bohrung 4 des Hochstromkontaktes 2 eingedrückt werden kann.

Zur zusätzlichen mechanischen Festlegung des Hochstromkontaktes an der Leiterplatte 1 kann dieser in einen blockförmigen Kunststoffkörper 12 eingefügt sein, der seinerseits mit nicht dargestellten Verbindungsmitteln, z.B. federnden Haken, mit der Leiterplatte 1 mechanisch verbunden werden kann.

Fig. 2 und Fig. 3 zeigen, daß die gesondert hergestellten Anschlußstifte 6 auch dazu verwendet werden können, um einen im wesentlichen hohlzylindrisch ausgebildeten metallischen Außenleiter 13 einer Koaxialsteckverbinderhälfte 14 elektrisch an eine Leiterplattenverdrahtung anschließen zu können.

Hierzu ist der Außenleiter 13 mit Längsbohrungen 16 versehen, die von einer Leiterplattenseite 15 der Steckverbinderhälfte 14 her zugänglich sind. In diese Längsbohrungen 16 sind Anschlußstifte 6 mit dem nagelförmig ausgebildeten Abschnitt 5 eingesteckt. Die Bemessung der Anschlußstifte 6 und der Bohrungen 16 ist dabei so getroffen, daß die Anschlußstifte 6 auf der Leiterplattenseite 15 der Steckverbinderhälfte 14 so weit vorstehen, daß der Einpreßabschnitt 8 eines jeden Anschlußstiftes 6 in eine entsprechend vorgesehene Bohrung der Leiterplatte eindringt, wenn die Steckverbinderhälfte 14 mit ihrer Leiterplattenseite 15 auf die Leiterplatte aufgesetzt wird.

Der Innenleiter 17 kann dabei dem Anschlußstift des Hochstromkontaktes 2 entsprechend ausgebildet sein.

## Patentansprüche

1. Koaxialsteckverbinderhälfte (14) zur Verbindung mit einer Leiterplatte mit
a) einer hohlzylindrisch ausgebildeten metallischen Außenleiterhülse (13),
b) einem koaxial und isoliert in der Außenleiterhülse (13) angeordneten zentralen Kontaktstift (17),
c) mindestens einem neben dem zentralen Kontaktstift (17) an der Außenleiterhülse (13) angeordneten peripheren Anschlußstift (6),
d) wobei der zentrale Kontaktstift (17) und der periphere Anschlußstift (6) in jeweils eine zugeordnete Bohrung der Leiterplatte einsteckbar und mit einer zum Eindrücken in die jeweilige Leiterplattenbohrung bestimmten, durch Aufspaltung des entsprechenden Stiftbereiches gebildeten Einpreßzone (8) versehen sind,
**dadurch gekennzeichnet,** daß
e) der periphere Anschlußstift (6) mit einem von der Einpreßzone (8) abgewandten, nagelförmig ausgebildeten Abschnitt (5) in eine Längsbohrung (16) in der Wandung der Außenleiterhülse (13) eingesteckt ist.

2. Koaxialsteckverbinderhälfte nach Anspruch 1, **dadurch gekennzeichnet,** daß neben dem zentralen Kontaktstift (17) zwei einander diametral gegenüberliegende periphere Anschlußstifte (6) vorgesehen sind.

3. Koaxialsteckverbinderhälfte nach Anspruch 2, **dadurch gekennzeichnet,** daß die peripheren Anschlußstifte (6) zwischen dem nagelförmigen Abschnitt (5) und der Einpreßzone (8) mit einer flanschartigen Verbreiterung (10) mit zur Einpreßzone (8) weisenden Schultern (11) ausgebildet sind.

4. Koaxialsteckverbinderhälfte nach einem der Ansprüche 1 bis 3, **dadurch gekennzeichnet,** daß der zentrale Kontaktstift (17) in einer den peripheren Anschlußstiften (6) entsprechenden Weise ausgebildet ist.

## Claims

1. Coaxial plug connector half (14) for connecting to a printed circuit board, having
a) a metal external conductor sleeve (13) of hollow cylindrical design,
b) a central contact pin (17) arranged coaxially and in an insulated manner in the external conductor sleeve (13),
c) at least one peripheral connection pin (6) arranged next to the central contact pin (17) on the external conductor sleeve (13),
d) the central contact pin (17) and the peripheral connection pin (6) being insertable into one assigned hole each of the printed circuit board and provided with a press-in zone (8) intended for pressing in into the respective printed circuit board hole and formed by splitting up the corresponding pin region,
characterized in that
e) the peripheral connection pin (6) is inserted with a section (5), facing away from the press-in zone (8) and of nail-shaped design, into a longitudinal hole (16) in the wall of the external conductor sleeve (13).

2. Coaxial plug connector half according to Claim 1, characterized in that, in addition to the central contact pin (17), two peripheral connection pins (6) are provided which are diametrically opposite each other.

3. Coaxial plug connector half according to Claim 2, characterized in that the peripheral connection pins (6) are designed between the nail-shaped section (5) and the press-in zone (8) with a flange-like widening (10) which has shoulders (11) pointing towards the press-in zone (8).

4. Coaxial plug connector half according to one of Claims 1 to 3, characterized in that the central contact pin (17) is designed in a manner corresponding to the peripheral connection pins (6).

## Revendications

1. Moitié (14) d'un connecteur coaxial destinée à être réunie à une plaquette à circuits imprimés, comprenant
a) une douille métallique de forme cylindrique creuse (13) formant conducteur extérieur,
b) une broche centrale de contact (17) disposée coaxialement et en étant isolée dans la douille (13) formant conducteur extérieur,
c) au moins une broche périphérique de raccordement (6), disposée à côté de la broche centrale de contact (17) sur la douille (13) formant conducteur extérieur,
d) la broche centrale de contact (17) et la broche périphérique de contact (6) pouvant être enfichées dans des perçages associés de la plaquette à circuits imprimés et étant pourvues d'une zone pouvant être enfoncée (8) destinée à être repoussée dans le perçage de la plaquette à circuits imprimés, et formée par division de la partie correspondante de la tige,
caractérisée par le fait que
e) la broche périphérique de raccordement (6) est enfichée, par une section (5) réalisée en forme d'aiguille et tournée à l'opposé de la zone pouvant être enfoncée (8), dans un perçage longitudinal (16) ménagé dans la paroi de la douille (13) du conducteur extérieur.

2. Moitié de conducteur coaxial suivant la revendication 1, caractérisée par le fait qu'en dehors de la broche centrale de contact (17), il est prévu deux broches périphériques de raccordement (6), qui sont diamétralement opposées.

3. Moitié de conducteur coaxial suivant la revendication 2, caractérisée par le fait que les broches périphériques de raccordement (6) comportent, entre la section en forme d'aiguille (5) et la zone pouvant être enfoncée (8), un élargissement en forme de bride (10) comportant des épaulements (11) tournés vers la zone pouvant être enfoncée (8).

4. Moitié de connecteur coaxial suivant l'une des revendications 1 à 3, caractérisé par le fait que la broche centrale de contact (17) est réalisée d'une manière qui correspond aux broches périphériques de raccordement (6).
